# EUROPÄISCHE PATENTSCHRIFT

(11) **EP 1 259 967 B1**
(45) Veröffentlichungstag und Bekanntmachung des Hinweises auf die Patenterteilung: **19.08.2009**
(21) Anmeldenummer: 01913674.6
(22) Anmeldetag: 16.02.2001
(51) Int. Cl.: H01F 27/29

(54) **SPULENBAUGRUPPE MIT EINER LEITERPLATTE UND EINEM SPULENKÖRPER**
COIL ASSEMBLY WITH A CIRCUIT BOARD AND A COIL BODY
ENSEMBLE DE BOBINES COMPRENANT UNE CARTE A CIRCUITS IMPRIMES ET UN CORPS DE BOBINE

(30) Priorität: 29.02.2000 DE 10009500
(43) Veröffentlichungstag der Anmeldung: 27.11.2002
(73) Patentinhaber: SIEMENS AKTIENGESELLSCHAFT, 80333 München (DE)
(72) Erfinder: FABER, Stephan, 92245 Kümmersbruck (DE); MITLMEIER, Norbert, 92289 Ursensollen (DE); SCHÖNER, Peter, 92224 Amberg (DE)
(86) Internationale Anmeldenummer: PCT/DE2001/000623
(87) Internationale Veröffentlichungsnummer: WO 2001/065574

(56) Entgegenhaltungen:
- EP-A- 0 395 013
- DE-A- 19 616 078
- FR-A- 2 715 474
- PATENT ABSTRACTS OF JAPAN vol. 010, no. 205 (E-420), 17. Juli 1986 (1986-07-17) & JP 61 047611 A (MATSUSHITA ELECTRIC IND CO LTD), 8. März 1986 (1986-03-08)

## Beschreibung

Die vorliegende Erfindung betrifft eine Spulenbaugruppe mit einer Leiterplatte, einem Spulenkörper und mindestens einem Wicklungsdraht,
- wobei der Spulenkörper über Verbindungselemente mit der Leiterplatte verbunden ist,
- wobei die Verbindungselemente je einen Befestigungsbereich, einen Verbindungsbereich und einen Kontaktbereich aufweisen,
- wobei die Verbindungselemente über die Befestigungsbereiche im Spulenkörper gehalten sind,
- wobei der Wicklungsdraht ein Zwischenstück und Endbereiche aufweist,
- wobei das Zwischenstück um den Spulenkörper gewickelt ist, so dass es eine Spule mit mindestens einer Windung bildet,
- wobei die Endbereiche mit den Verbindungsbereichen der Verbindungselemente gelötet sind,
- wobei die Kontaktbereiche der Verbindungselemente in die Leiterplatte eingelötet sind.

Eine derartige Spulenbaugruppe ist aus der EP 0 698 278 Bl bekannt. Bei der dort beschriebenen Spulenbaugruppe befinden sich die Verbindungsbereiche auf der Bauelementseite der Leiterplatte, während die Kontaktbereiche durch Kontaktbohrungen hindurchragen. Bei der Montage der Spulenbaugruppe werden daher zunächst die Endbereiche des Wicklungsdrahtes um die Verbindungsbereiche gewickelt und mit diesen gelötet. Dann werden die Kontaktbereiche in die Kontaktbohrungen eingesetzt und in die Leiterplatte eingelötet.

Die Vorgehensweise des Standes der Technik ist zeit- und arbeitsintensiv und damit umständlich.

Die Aufgabe der vorliegenden Erfindung besteht darin, eine Spulenbaugruppe zu schaffen, die einfacher herstellbar ist.

Die Aufgabe wird durch die Merkmale des Anspruchs 1 gelöst.

Die Verbindungsbereiche und die Kontaktbereiche können miteinander identisch sein. Es ist also möglich, einen Verbindungs-/Kontaktbereich sowohl mit einem Endbereich des Wicklungsdrahtes zu löten als auch in die Leiterplatte einzulöten. Wenn aber die Verbindungsbereiche und die Kontaktbereiche separate Bereiche der Verbindungselemente sind, sind die Verbindungsbereiche und die Kontaktbereiche unabhängig voneinander für ihre jeweilige Aufgabe optimierbar. Insbesondere können Aufnahmebohrungen für die Verbindungs- bzw. die Kontaktbereiche stets gleich angeordnet und dimensioniert sein. Denn dann können die Kontaktbereiche stets dieselben Abmessungen aufweisen, während zwischen Verbindungsbereichen und Leiterplatte kein elektrischer Kontakt erforderlich ist.

Aufgrund dieser Ausbildung ist es möglich, dass die Verbindungsbereiche am Rand der Leiterplatte angeordnet sind. Alternativ dazu ist es möglich, dass die Verbindungsbereiche durch Verbindungsbohrungen der Leiterplatte ragen, die Kontaktbereiche durch Kontaktbohrungen der Leiterplatte ragen und die Verbindungsbohrungen größer sind als die Kontaktbohrungen.

Wenn die Verbindungsbereiche und die Kontaktbereiche gleich ausgebildet sind, ist ein "Rollentausch" zwischen den beiden Bereichen möglich.

Wenn die Verbindungselemente symmetrisch ausgebildet sind, ist eine flexiblere Handhabung möglich. Beispielsweise können die Verbindungselemente gabelförmig ausgebildet sein.

Die Herstellung der Verbindungselemente ist besonders einfach, wenn sie Stanzteile sind.

Wenn die Endbereiche des Wicklungsdrahtes um die Verbindungsbereiche gewickelt sind, ergibt sich auf einfache Weise eine Vorfixierung der Endbereiche vor dem Löten mit den Verbindungsbereichen.

Weitere Vorteile und Einzelheiten ergeben sich aus der nachfolgenden Beschreibung eines Ausführungsbeispiels. Dabei zeigen in Prinzipdarstellung
- FIG 1: eine Spulenbaugruppe,
- FIG 2: ein Verbindungselement,
- FIG 3: eine Leiterplatte mit einem Verbindungselement und
- FIG 4: eine Variante von FIG 3.

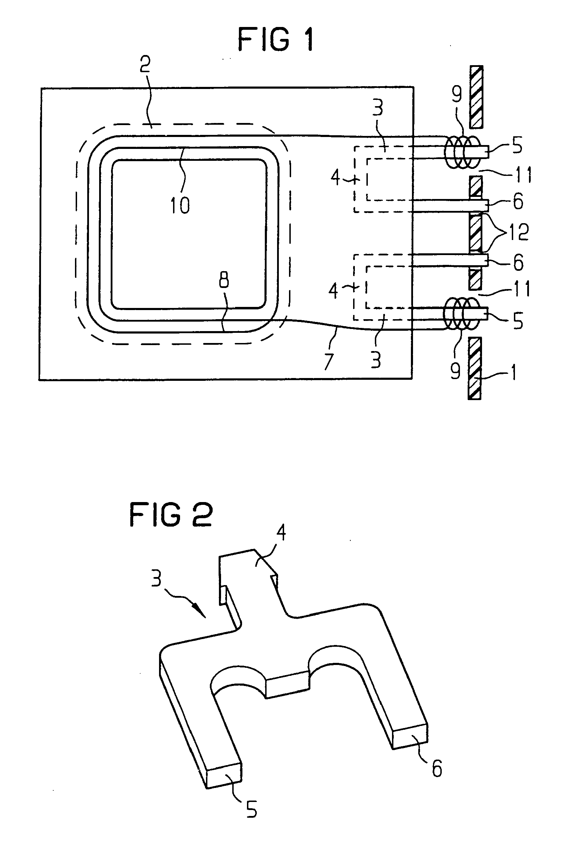

Gemäß FIG 1 weist eine Spulenbaugruppe eine Leiterplatte 1 und einen Spulenkörper 2 auf. Der Spulenkörper 2 ist über Verbindungselemente 3 mit der Leiterplatte 2 verbunden. Die Verbindungselemente 3 weisen dabei - siehe auch FIG 2 - je einen Befestigungsbereich 4, einen Verbindungsbereich 5 und einen Kontaktbereich 6 auf. Die Verbindungselemente 3 sind über die Befestigungsbereiche 6 im Spulenkörper 2 gehalten.

Ein Wicklungsdraht 7 weist ein Zwischenstück 8 und Endbereiche 9 auf. Das Zwischenstück 8 ist um den Spulenkörper 2 gewickelt, so dass es eine Spule mit mindestens einer Windung 10 bildet. Die Endbereiche 9 sind um die Verbindungsbereiche 5 gewickelt und mit diesen über Lötverbindungen elektrisch leitend verbunden. Die Kontaktbereiche 6 sind in die Leiterplatte 1 eingelötet.

Gemäß FIG 1 ragen die Verbindungsbereiche 5 durch Verbindungsbohrungen 11 der Leiterplatte 1, die Kontaktbereiche 6 durch Kontaktbohrungen 12 der Leiterplatte 1. Bei der Fertigung der Spulenbaugruppe werden zunächst die Endbereiche 9 um die Verbindungsbereiche 5 gewickelt und dann die Verbindungsbereiche 5 und die Kontaktbereiche 6 durch die entsprechenden Bohrungen 11, 12 geführt. Damit die zu diesem Zeitpunkt nur vorfixierten Endbereiche 9 problemlos in die Verbindungsbohrungen 11 eingeführt bzw. durch diese durchgeführt werden können, sind die Verbindungsbohrungen 11 groß dimensioniert, in jedem Fall größer als die Kontaktbohrungen 12.

Die Verbindungselemente 3 sind also derart ausgebildet, dass sowohl die die Endbereiche 9 tragenden Verbindungsbereiche 5 als auch die Kontaktbereiche 6 durch die Leiterplatte 1 ragen. Dadurch ist es möglich, während eines einzigen Lötvorgangs sowohl die Endbereiche 9 mit den Verbindungsbereichen 5 zu löten als auch die Kontaktbereiche 6 in die Leiterplatte 1 einzulöten.

Gemäß FIG 2 sind die Verbindungselemente 3 als symmetrische, gabelförmige Stanzteile ausgebildet. Die Verbindungsbereiche 5 und die Kontaktbereiche 6 sind als separate, gleich ausgebildete Bereiche 5, 6 ausgebildet.

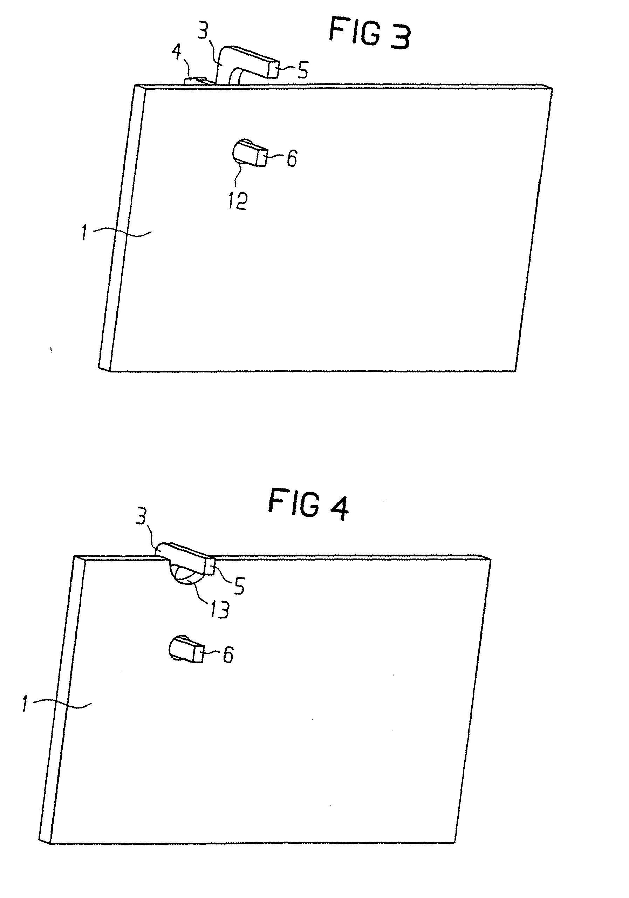

Gemäß FIG 1 ragen die Verbindungsbereiche 5 durch die Verbindungsbohrungen 11. Alternativ zum Vorsehen von Verbindungsbohrungen 11 ist es gemäß den FIG 3 und 4 aber auch möglich, die Verbindungsbereiche 5 am Rand der Leiterplatte 1 anzuordnen. Gemäß FIG 3 steht der Verbindungsbereich 5 dabei völlig über die Leiterplatte 1 über, gemäß FIG 4 ist er in einer halbkreisförmigen Ausnehmung 13 angeordnet. Die Endbereiche 9 des Wicklungsdrahtes 7 sind in den FIG 3 und 4 der vereinfachten Darstellung wegen nicht dargestellt.

Gemäß Ausführungsbeispiel wurde eine Spulenbaugruppe gezeigt, die eine Spule aufweist. Es könnten aber auch mehrere, getrennt voneinander schaltbare Spulen vorgesehen sein. In diesem Fall müssten lediglich mehr als zwei Verbindungselemente 3 verwendet werden.

## Patentansprüche

1. Spulenbaugruppe mit einer Leiterplatte (1), einem Spulenkörper (2) und mindestens einem Wicklungsdraht (7),
- wobei der Spulenkörper (2) über Verbindungselemente (3) mit der Leiterplatte (1) verbunden ist,
- wobei die Verbindungselemente (3) je einen Befestigungsbereich (4), einen Verbindungsbereich (5) und einen Kontaktbereich (6) aufweisen,
- wobei die Verbindungselemente (3) über die Befestigungsbereiche (4) im Spulenkörper (2) gehalten sind,
- wobei der Wicklungsdraht (7) ein Zwischenstück (8) und Endbereiche (9) aufweist,
- wobei das Zwischenstück (8) um den Spulenkörper (2) gewickelt ist, so dass es eine Spule mit mindestens einer Windung (10) bildet,
- wobei die Endbereiche (9) mit den Verbindungsbereichen (5) der Verbindungselemente (3) gelötet sind,
- wobei die Kontaktbereiche (6) der verbindungselemente (3) in die Leiterplatte (1) eingelötet sind,
**dadurch gekennzeichnet,**
**dass** die Verbindungselemente (3) derart ausgebildet sind, dass die Verbindungsbereiche (5) und die Kontaktbereiche (6) entweder am Rand der Leiterplatte (1) angeordnet sind, oder durch Verbindungsbohrungen (11) der Leiterplatte (1) ragen, so dass das Löten der Endbereiche (9) des Wicklungsdrahtes (7) mit den Verbindungsbereichen (5) der Verbindungselemente (3) und das Einlöten der Kontaktbereiche (6) der Verbindungselemente (3) in die Leiterplatte (1) während eines einzigen Lötvorganges erreichbar ist.

2. Spulenbaugruppe nach Anspruch 1,
**dadurch gekennzeichnet,**
**dass** die Verbindungsbereiche (5) und die Kontaktbereiche (6) separate Bereiche (5, 6) der Verbindungselemente (3) sind.

3. Spulenbaugruppe nach Anspruch 2,
**dadurch gekennzeichnet,**
**dass** die Kontaktbereiche (6) durch Kontaktbohrungen (12) der Leiterplatte (1) ragen und dass die Verbindungsbohrungen (11) größer sind als die Kontaktbohrungen (12).

4. Spulenbaugruppe nach Anspruch 2 oder 3,
**dadurch gekennzeichnet,**
**dass** die Verbindungsbereiche (5) und die Kontaktbereiche (6) gleich ausgebildet sind.

5. Spulenbaugruppe nach einem der obigen Ansprüche,
**dadurch gekennzeichnet,**
**dass** die Verbindungselemente (3) symmetrisch ausgebildet sind.

6. Spulenbaugruppe nach Anspruch 4 und 5,
**dadurch gekennzeichnet,**
**dass** die Verbindungselemente (3) gabelförmig ausgebildet sind.

7. Spulenbaugruppe nach einem der obigen Ansprüche,
**dadurch gekennzeichnet,**
**dass** die Verbindungselemente (3) Stanzteile sind.

8. Spulenbaugruppe nach einem der obigen Ansprüche,
**dadurch gekennzeichnet,**
**dass** die Endbereiche (9) des Wicklungsdrahtes (7) um die Verbindungsbereiche (5) gewickelt sind.

## Claims

1. Coil assembly having a printed circuit board (1), a coil body (2) and at least one winding wire (7),
- wherein the coil body (2) is connected to the circuit board (1) via connection elements (3),
- wherein the connection elements (3) each have an attachment area (4), a connection area (5) and a contact area (6),
- wherein the connection elements (3) are held in the coil body (2) via the attachment areas (4),
- wherein the winding wire (7) has a spacer (8) and end areas (9),
- wherein the spacer (8) is wound around the coil body (2) so that it forms a coil with at least one winding (10),
- wherein the end areas (9) are soldered to the connection areas (5) of the connection elements (3),
- wherein the contact areas (6) of the connection elements (3) are soldered into the circuit board (1),
**characterised in that**
the connection elements (3) are designed such that the connection areas (5) and the contact areas (6) are arranged either on the edge of the circuit board (1), or project through connection holes (11) in the circuit board (1), so that the soldering of the end areas (9) of the winding wire (7) to the connection areas (5) of the connection elements (3) and the soldering of the contact areas (6) of the connection elements (3) into the circuit board (1) can be achieved in a single soldering operation.

2. Coil assembly according to claim 1,
**characterised in that**
the connection areas (5) and the contact areas (6) are separate areas (5, 6) of the connection elements (3).

3. Coil assembly according to claim 2,
**characterised in that**
the contact areas (6) project through contact holes (12) in the circuit board (1) and **in that** the connection holes (11) are bigger than the contact holes (12).

4. Coil assembly according to claim 2 or 3,
**characterised in that**
the connection areas (5) and the contact areas (6) are of identical design.

5. Coil assembly according to one of the preceding claims,
**characterised in that**
the connection elements (3) are designed to be symmetrical.

6. Coil assembly according to claim 4 and 5,
**characterised in that**
the connection elements (3) are designed in the shape of a fork.

7. Coil assembly according to one of the preceding claims,
**characterised in that**
the connection elements (3) are stamped parts.

8. Coil assembly according to one of the preceding claims,
**characterised in that**
the end areas (9) of the winding wire (7) are wound around the connection areas (5).

## Revendications

1. Ensemble de bobine comprenant une carte à circuits imprimés (1), un corps de bobine (2) et au moins un fil d'enroulement (7),
- le corps de bobine (2) étant relié à la carte à circuits imprimés (1) par l'intermédiaire d'éléments de liaison (3),
- les éléments de liaison (3) présentant chacun une zone de fixation (4), une zone de liaison (5) et une zone de contact (6),
- les éléments de liaison (3) étant maintenus dans le corps de bobine (2) par l'intermédiaire des zones de fixation (4),
- le fil d'enroulement (7) présentant une partie intermédiaire (8) et des zones d'extrémité (9),
- la partie intermédiaire (8) étant enroulée autour du corps de bobine (2) de manière telle qu'elle forme une bobine avec au moins une spire (10),
- les zones d'extrémité (9) étant brasées aux zones de liaison (5) des éléments de liaison (3),
- les zones de contact (6) des éléments de liaison (3) étant brasées dans la carte à circuits imprimés (1),
**caractérisé en ce que**
les éléments de liaison (3) sont réalisés de manière telle que les zones de liaison (5) et les zones de contact (6) soit sont situées au bord de la carte à circuits imprimés (1) soit font saillie hors de perçages de liaison (11) de la carte à circuits imprimés de sorte que le brasage des zones d'extrémité (9) du fil d'enroulement (7) aux zones de liaison (5) des éléments de liaison (3) et le brasage des zones de contact (6) des éléments de liaison (3) dans la carte à circuits imprimés peuvent être obtenus en une seule opération de brasage.

2. Ensemble de bobine selon la revendication 1, **caractérisé en ce que** les zones de liaison (5) et les zones de contact (6) sont des zones séparées (5, 6) des éléments de liaison (3).

3. Ensemble de bobine selon la revendication 2, **caractérisé en ce que** les zones de contact (6) font saillie hors de perçages de contact (12) de la carte à circuits imprimés (1) et **en ce que** les perçages de liaison (11) sont plus grands que les perçages de contact (12).

4. Ensemble de bobine selon la revendication 2 ou 3, **caractérisé en ce que** les zones de liaison (5) et les zones de contact (6) sont réalisées à l'identique.

5. Ensemble de bobine selon l'une des revendications précédentes, **caractérisé en ce que** les éléments de liaison (3) sont réalisés symétriquement.

6. Ensemble de bobine selon la revendication 4 et 5, **caractérisé en ce que** les éléments de liaison (3) sont réalisés en forme de fourchette.

7. Ensemble de bobine selon l'une des revendications précédentes, **caractérisé en ce que** les éléments de liaison (3) sont des pièces estampées.

8. Ensemble de bobine selon l'une des revendications précédentes, **caractérisé en ce que** les zones d'extrémité (9) du fil d'enroulement (7) sont enroulées autour des zones de liaison (5).
